# EUROPEAN PATENT APPLICATION

(11) **EP 4 395 477 A1**
(43) Date of publication of application: **03.07.2024**
(21) Application number: 23212990.8
(22) Date of filing: 29.11.2023
(51) Int. Cl.: H05K 1/18, H05K 3/42, H05K 3/46, H05K 1/11

(54) **A COMPONENT CARRIER ASSEMBLY AND METHOD FOR MANUFACTURING A COMPONENT CARRIER ASSEMBLY**

(30) Priority: 22.12.2022 EP 22306993
(71) Applicant: AT & S Austria Technologie & Systemtechnik Aktiengesellschaft, 8700 Leoben-Hinterberg (AT)
(72) Inventor: RIESER, Michael, 8741 Weißkirchen (AT); TRISCHLER, Heinrich, 8063 Eggersdorf (AT); ZIPPER, Wolfgang, 8330 Feldbach (AT); SCHLICK, Daniel, 8733 St. Marein-Feistritz (AT); SCHLAFFER, Erich, 8642 St. Lorenzen (AT)
(74) Representative: Burger, Hannes

(57) **Abstract**

The invention relates to a component carrier assembly (1) comprising:
a component carrier (2), and
an electronic component (10) at least partially embedded within the component carrier (2),
wherein at least one electrically insulating layer structure (3) covers at least a first surface (11) of the electronic component (10),
wherein the electronic component (10) comprises at least one electrically conductive portion (12) at its first surface (11),
wherein at least one feedthrough (5) is formed in the electrically insulating layer structure (3), said at least one feedthrough (5) positionally matches with the at least one electrically conductive portion (12),
wherein an electrically conductive path (6) extends from the at least one electrically conductive portion (12) through the feedthrough (5), wherein the electrically conductive path (6) comprises
a first portion (7) covering at least a portion of the electrically conductive portion (12), said first portion (7) also covering at least a portion of the stack (4), and
a second portion (8) that covers the first portion (7), said second portion (8) being separated from the electrically conductive portion (12) by the first portion (7),
wherein the first portion (7) is formed from a first material, the second portion (8) is formed from a second material and the electrically conductive portion (12) of the electronic component (10) is formed from a third material, wherein the first, second and third material are different from each other.

## Description

The invention relates to a component carrier assembly comprising a component carrier and an electronic component at least partially, preferably fully, embedded within the component carrier, wherein the component carrier comprises a stack, said stack comprising at least one electrically conductive layer structure and electrically insulating layer structures, wherein at least one electrically insulating layer structure covers at least a first surface of the electronic component, wherein the electronic component comprises at least one electrically conductive portion, preferably a plurality of electrically conductive portions, at its first surface for establishing an electrical connection to the functional portion of the electronic component. The invention relates to a method for manufacturing a component carrier assembly.

For some applications the exposed electrically conductive portions, such as pads, of electronic components are made from material that is difficult to contact and/or susceptible to corrosion and/or must not be brought into contact with acid or alkaline wet chemistry and/or must not be treated by etching. One of these components are components with aluminium pads. There does not exist a production method for embedding such components and at the same time establishing a sustainable and reliable electrical contact to these pads.

KR101061792B1 discloses a chip-embedded printed circuit board. In one embodiment an upper carrier and a lower carrier are adhesively bonded together so that the chip is embedded in the intermediate insulating layer. By pressing and heating, the resin of the intermediate insulating layer is cured and bonded to the upper and lower carriers. Electrical connection to the chip is established by means of a chip connecting portion. Disadvantages of such a PCB consist in the fact, that the electrical contact is not reliable and protection of the pads of the chip from adverse impacts is not guaranteed.

US9978677 discloses a method for fabricating a contact via structure. This document, however, does not contain any teaching regarding the reliable contacting of embedded electronic components.

It has been the object of the present invention to overcome the disadvantages of the prior art and to provide a component carrier assembly and method by means of which a sustainable and reliable electrical contact may be established to the exposed electrically conductive portions of the electronic component. Moreover, the electrically conductive portions of the electronic component should be protected from adverse impacts during the manufacturing method but also in the assembled and contacted state. The structure of the component carrier assembly as well as the method should guarantee an efficient and cost-effective production.

This object is achieved by a component carrier assembly comprising:
- a component carrier, and
- an electronic component at least partially, preferably fully, embedded within the component carrier,
   wherein the component carrier comprises a stack, said stack comprising at least one electrically conductive layer structure and electrically insulating layer structures,
   wherein at least one electrically insulating layer structure covers at least a first surface of the electronic component,
   wherein the electronic component comprises at least one electrically conductive portion, preferably a plurality of electrically conductive portions, at its first surface for establishing an electrical connection to the functional portion of the electronic component,
   wherein at least one feedthrough is formed in the electrically insulating layer structure, said at least one feedthrough positionally matches with the at least one electrically conductive portion of the electronic component,
   wherein an electrically conductive path extends from the at least one electrically conductive portion of the electronic component through the feedthrough, wherein the electrically conductive path comprises
- a first portion, preferably formed as a layer, said first portion covering (and preferably adhering to) at least a portion of the electrically conductive portion of the electronic component, said first portion also covering at least a portion of the stack, preferably at least a portion of the electrically insulating layer structure, and
- a second portion, preferably formed as a layer, that covers (and preferably adheres to) the first portion, said second portion being separated from the electrically conductive portion of the electronic component by the first portion,
wherein the first portion is formed from a first material, the second portion is formed from a second material and the electrically conductive portion of the electronic component is formed from a third material, wherein the first material is different to the third material, wherein preferably the first material is different to the second material and different to the third material, wherein preferably the second material and the third material are different from each other. The first portion, that not only covers (a portion of) the electrically conductive portion of the electronic component but also at least a portion of the stack surrounding the electronic component, guarantees that the electrically conductive portion of the electronic component is reliably protected. It is preferred if the first portion (formed from the first material) together with at least a portion of the stack (such as at least a portion of the electrically insulating layer structure) - preferably hermetically - seals the electrically conductive portion of the electronic component to the outside of the component carrier assembly. Moreover, by using different materials the adhesion properties between the materials may be increased and optimized. With other words: the first portion forms an intermediate (layer) portion between the electrically conductive portion (third material) of the electronic component and the second portion (second material). The first portion acts as an interface between the material of the electrically conductive portion of the electronic component and the second material commonly used for electrically conductive layer structures within the stack.

It is understood that a "material" in the sense of the present application may comprise one or more type(s) of element(s). It is further understood, that even if two of the (first, second and third) materials comprise the same element, but differ in another element and/or in composition and/or in element ratio, they are considered as being different from each other. For example, if the first material is a TiW alloy and second material is Ti, they are of course different to each other.

In the context of the present application, the term "component carrier assembly" is understood as a combination of a component carrier and at least one electronic component.

In the context of the present application, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, and an IC (integrated circuit) substrate. A component carrier may also be a hybrid board combining different ones of the above mentioned types of component carriers.

In the context of the present application, the term "stack" may particularly denote an arrangement of multiple planar layer structures which are mounted in parallel on top of one another.

In the context of the present application, the term "layer structure" may particularly denote a continuous layer, a patterned layer or a plurality of non-consecutive islands within a common plane.

In the context of the present application, the term "main surface" of a body may particularly denote one of two largest opposing surfaces of the body. The main surfaces may be connected by circumferential side walls. The thickness of a body, such as a stack, may be defined by the distance between the two opposing main surfaces.

Preferably, the component carrier assembly is a printed circuit board (PCB) and/or a substrate (such as an IC substrate) and/or an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, bismaleimidetriazine resin, polyphenylene derivate (for example based on polyphenylenether, PPE), polyimide (PI), polyamide (PA), liquid crystal polymer (LCP), polytetrafluoroethylene (PTFE) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, for example fibers impregnated with the above-mentioned resins is called prepreg. These prepregs are often named after their properties for example FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

Preferably, the electronic component is and/or comprises a chip and/or an integrated circuit (IC). The electronic component may be an active device, but may also be a passive device such as a capacitor, an inductor, or a resistor, or a combination thereof.

Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga2O3), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microe-lectromechanical system (MEMS), a microprocessor, a capacitor, a resistor, an inductance, a battery, a switch, a camera, an antenna, a logic chip, and an energy harvesting unit. However, other components may be embedded in the component carrier. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

In the context of the present application, the term "inorganic layer structure" may particularly denote a layer structure which comprises inorganic material, such as an inorganic compound. In particular, dielectric material of the inorganic layer structure or even the entire inorganic layer structure may be made exclusively or at least substantially exclusively from inorganic material. In another embodiment, the inorganic layer structure may comprise inorganic dielectric material and additionally another dielectric material. An inorganic compound may be a chemical compound that lacks carbon-hydrogen bonds or a chemical compound that is not an organic compound. In an example, the inorganic layer structure may comprise glass, for example silicon base glass, in particular soda lime glass, and/or boro-silicate glass and/or alumo-silicate glass and/or lithium silicate glass and/or alkaline free glass. In another example, the inorganic layer structure may comprise ceramic material, for example aluminum nitride and/or aluminum oxide and/or silicon nitride and/or boron nitride and/or tungsten comprising ceramic material. Yet, in another example, the inorganic layer structure may comprise semi-conducting material, for example silicon and/or germanium and/or silicon oxide and/or germanium oxide and/or silicon carbide and/or gallium nitride. In a further embodiment, the inorganic layer structure may comprise (elemental) metal and/or metal alloys, for example, copper and/or tin and/or bronze. Yet in another embodiment, the inorganic layer structure may comprise inorganic material, which is not listed in the above mentioned example, such as: MoS2, CuGaO2, AgAlO2, LiGaTe2, AgInSe2, CuFeS2, BeO.

Preferably, the electrically conductive layer structure is and/or comprises a trace, such as horizontal trace and/or vertical trace (via), and/or a combination of (patterned) traces and/or a pad and/or a land and/or a connecting lip. The electrically conductive layer structure may comprise inorganic material, for example a metal, for example copper or nickel, and/or a metal salt, for example silver oxide, and/or a ceramic material, for example indium tin oxide, and/or a glass material, and/or a carbon comprising material, for example graphene. Additionally and/or alternatively, the electrically conductive layer structure may comprise organic material, for example electrically conductive polymers, for example Poly(3,4-ethylenedioxythiophene) (PEDOT).

Preferably, the electrically insulating layer structure comprises organic material, which may be optionally reinforced by reinforcing material. Said reinforcing material may comprise fibres and/or sphere. Preferably the reinforcing material may comprise or consist of glass. In an example the electrically insulating layer structure comprises one of: polyepoxide resin, polyimide resin, polyamide resin, polyacrylate resin, polymethacrylate resin. In a futher example, the electrically insulating layer structure comprises or consist of glass material and/or ceramic material.

Preferably, the stack comprises a plurality of electrically conductive layer structures and/or electrically insulating layer structure, which are ordered adjacent to each other along stack thickness direction which is perpendicular to the main elongation direction. Preferably, the layers of the stack are aligned parallel. Thereby a first layer of the stack and a second layer of the stack may sandwich at least one further layer in between.

The feedthrough, sometimes also denoted as through, may be an opening, a hole or a passage extending through the electrically insulating layer structure (and being free of the material of the electrically insulating layer structure). The feedthrough may extend transversely, preferably perpendicularly, to the surface plane of the electrically insulating layer structure. Particularly, the feedthrough may be a vertical through for forming a so called (vertical) via inside. The feedthrough can be at partially, preferably fully, filled with first material of the first portion of the electrically conductive path and/or second material of the second portion of the electrically conductive path.

The first portion of the electrically conductive path may cover at least a portion of the electrically conductive portion of the electronic component, such that an electrical contact can be established between first portion and electrically conductive portion of the electronic component. It is preferred that the first portion adheres to at least a portion of the electrically conductive portion of the electronic component. This may bring the advantage of ensuring reliable mechanical connection in addition to the provision of electrical conductivity.

The second portion of the electrically conductive path covers the first portion, such that an electrical contact is established between the second portion and the first portion. In a preferred embodiment the second portion covers at least 80%, preferably at least 90%, of the first portion, preferably one side of the first portion. It is preferred that the second portion adheres to the first portion. Consequently, the first portion may act as an interface and/or bridge between the electrically conductive portion of the electronic component and the second portion and consequently with a further portion of the electrically conductive layer structure of the component carrier, even if the materials between said electrically conductive portion is not suitable for a reliable connection with the material of the second portion (for example being the material of the second portion the same and/or compatible with the material of the connected portion of the electrically conductive layer structure).

According to a preferred embodiment, the at least one feedthrough and the electrically conductive path extend to an external side of the component carrier. Alternatively, the feedthrough may (also) extend to a (further) electrically conductive layer structure. This allows an electrical connection to externally exposed portions of an electrically conductive layer structure and/or to a further portion of the electrically conductive layer structure of the component carrier. Said external side (to which the feedthrough and the electrically conductive path extend) may be the external side to which the first surface of the electronic component faces. However, said external side may also be the opposed external side, wherein the connection may be established via an (additional) through connection. Alternatively, said external side may be a main surface of a (intermediate) layer of the stack.

According to a preferred embodiment, the first portion extends at least partially, preferably fully, through the feedthrough, preferably to the external side of the component carrier, wherein preferably the first portion forms a - partial or complete - lining of the interior wall of the feedthrough. Due to the fact, that the first portion (already covering the electrically conductive portion of the electronic component) also covers the interior wall of the feedthrough, the separation/protection of the electrically conductive portion of the electronic component is made more efficient and reliable. With other words: the electrically conductive portion of the electronic component is optimally sealed to the outside. Alternatively, the first portion extends at least partially, preferably fully, through the feedthrough, preferably to one of the main surfaces of the layer structure composing the stack of the component carrier.

According to a preferred embodiment, the second portion extends through the feedthrough, preferably to the external side of the component carrier. Alternatively, the second portion extends through the feedthrough, preferably to one of the main surfaces of the layer structure composing the stack of the component carrier. The second portion may further increase protection of the electrically conductive portion(s) of the electronic component and at the same time guarantees a reliable electrical connection. Additionally, the lining of the external side of the component carrier can be the footprint of a layer formed in a panel level construction, stacking one layer above the other, then resulting in a second portion planarly extending as the other layers (and then eventually patterned) manufactured in a known, optimized and cheap way.

In a preferred embodiment the second portion is formed with a protrusion extending beyond the surface of the electrically insulating structure. In such a way the (inter)connections with other parts, components, PCBs, etc. may be improved.

According to a preferred embodiment, the first portion covers an external surface of the electrically insulation layer structure at least in an area of the feedthrough. The extension of the first portion from the bottom of the feedthrough (i.e. from the electrically conductive portion of the component) to the external surface of the electrically insulation layer structure efficiently increases the sealing function/efficiency of the first portion (to protect the electrically conductive portion of the component).

In a further embodiment the first portion may be exposed via its sidewall; this can be the case of the first portion extending to one of the main surfaces of the layer composing the stack of the component carrier, where the first portion is covered by a further layer structure, then exposing the sidewalls only; according to a further or alternative embodiment, a main surface of the first portion having an area smaller than 500 µm² is exposed. This may bring the advantage of decreasing the risk of decomposition, in particular oxidation, of the first portion and thus ensures high mechanical reliability. The exposure of the first portion having an area smaller than 500 µm² may result from the involved method and thus may be a fingerprint feature.

According to a preferred embodiment, the first material is or comprises an element selected from Sc, Y, La, Ti, Zr, Hf, V, Nb, Ta, Cr, Mo, W, Mn, Tc or Re, wherein preferably the first material is or comprises titanium, chromium or tungsten. With other words: the first material is or comprises an element from the third to seventh group of the periodic table and/or comprises at least one element from the third to seventh group of the periodic table.

In particular, the first material may be
- an alloy between those elements/metals, such as TiW, VW, TiNb, NbTa, CrW, or TiCr;
- an oxide from one or more of those elements/metals, such as TiO, TiO₂, Sc₂O₃, ZrO₂, VO, V₂O₅, Nb₂O₅, Ta₂O₅, CrO, Cr₂O₃, MoO, Mo₂O₃, MoO₂, WO, W₂O₃, or WO₂;
- a nitride from one or more of those elements/metals, such as Ti₃N₂, Ti₃N₄, ScN, Zr₃N₄, V₃N₂, V₃N₅, Nb₃N₅, Ta₃N₅, Cr₃N₂, CrN, Mo₃N₂, MoN, Mo₃N₄, W₃N₂, WN, W₃N₄;
- a selenide from one or more of those elements/metals, such as TiSe, TiSe₂, Sc₂Se₃, ZrSe₂, VSe, V₂Se₅, Nb₂Se₅, Ta₂Se₅, CrSe, Cr₂Se₃, MoSe, Mo₂Se₃, MoSe₂, WSe, W₂Se₃, or WSe₂;
- an antimonide from one or more of those elements/metals, such as Ti₃Sb₂, Ti₃Sb₄, ScSb, Zr₃Sb₄, V₃Sb₂, V₃Sb₅, Nb₃Sb₅, Ta₃Sb₅, Cr₃Sb₂, CrSb, Mo₃Sb₂, MoSb, Mo₃Sb₄, W₃Sb₂, WSb, or W₃Sb₄; or
- an arsenide from one or more of those elements/metals, such as Ti₃As₂, Ti₃As₄, ScAs, Zr₃As₄, V₃As₂, V₃As₅, Nb₃As₅, Ta₃As₅, Cr₃As₂, CrAs, Mo₃As₂, MoAs, Mo₃As₄, W₃As₂, WAs, or W₃As₄

All of those may bring the advantage of good adhesion to the second material and/or the third material, due to chemical affinity.

Additionally, they may act as a barrier layer which suppresses diffusion and/or migration of the material of the second portion and/or the third portion.

Additionally, the first material may comprise at least two of the above listed materials (any combination may be possible). A combination of Ti and TiW would be a very preferred choice for the first material.

Titanium, chromium, or tungsten are the preferred element for the first material.

According to a preferred embodiment, the second material is or comprises an element selected from Sc, Ti, V, Cr, Mn, Fe, Co, Ni, Cu, Zn, Ru, Rh, Pd, Ag, Cd, Os, Ir, Pt, Au, or Hg, preferably Ti, Cr, Ni, Cu, Pd, Ag, Ir, or Au, wherein further preferably the second material is or comprises copper.

With other words: the second material is or comprises a transition metal, in particular from the third to the twelfth group of the periodic table. Further preferred second materials are compounds free of non-metals-, for example oxide-, nitride- free compounds (so only metals or alloys are created). Preferably, the second material may have an electrical conductivity higher than 10⁵ S/m and/or a thermal conductivity higher than 10 W/mK. Alternatively, the second material may have an electrical conductivity lower than 10⁵ S/m and/or a thermal conductivity lower than 10 W/mK. This may bring the advantage of imparting dedicated physical and/or chemical properties to the electrically conductive path, for example Youngs Modulus, CTE (chemical thermal expansion), electrical and/thermal resistance. Furthermore, a big pool of different materials may bring the advantage of creating/manufacturing a component carrier assembly and/or component carrier having desired properties and may enable flexible manufacturing using the described method.

According to a preferred embodiment, the third material is different from copper and/or free of copper and/or wherein the third material is or comprises an element selected from Sc, Ti, V, Cr, Mn, Fe, Co, Ni, Zn, Al, Ga, In, Tl, Sn, or Pb, or wherein the third material is carbon, such as graphene, or electrically conductive polymer, such as PEDOT, wherein preferably the third material is or comprises aluminium. This may bring the advantage of enabling a reliable physical and/or electrical connection via the to the feedthrough to the electronic component, whereas the material of third material of the electronic component may be composed of a big variety of different materials having different physical and/or chemical properties. Such a tailored connected may ensure long term performance of the electronic component, since the method may adapt to the required circumstances.

According to a preferred embodiment, the surface of the first portion facing the electrically conductive portion of the electronic component defines a protecting surface interface, said surface interface being free of carbon and/or free of oxygen and/or free of at least oxides based on atoms of the third material, preferably free of any oxides. It is preferred if the surface interface is free of carbon/oxygen/oxides flushes with the rest of the conductive portion.

This may reduce the electrical and/or thermal resistivity and thus ensures fast signal and/or good heat transmission. Furthermore, a reliable adhesion or cohesion may be enabled between the first portion and the third material of the electrically conductive portion.

According to a preferred embodiment, the at least one electrically conductive portion of the electronic component is the component pad or is a layer overlapping said pad, preferably preventing exposure of said component pad. This may bring the advantage of shortening the electrical and/or thermal conductive path and thus may enable a fast signal transmission or a reliable heat guiding between the at least one electrically conductive portion and the external side of the component carrier.

In a preferred embodiment the feedthrough is acentric (off-center) with respect to the corresponding electrically conductive portion (i.e. the electrically conductive portion positionally matching with said feedthrough), wherein preferably the cross-sectional area of the feedthrough is smaller than the total surface area of the electrically conductive portion. With other words: the center of the cross-sectional area of the feedthrough is not aligned with the center of the total surface area of the electrically conductive portion (positionally matching with said feedthrough). This embodiment allows deviations of a centered alignment without diminishing the quality of the electrical contact. This embodiment allows more tolerances of the manufacturing method (e.g. the laser drilling of the feedthroughs) and makes it more cost effective.

According to a preferred embodiment, the contact area of the electrically conductive portion with the first portion corresponds to at least 60%, preferably to at least 80%, of the total surface area of the electrically conductive portion. The remaining portion is preferably covered and protected by the electrically insulating layer structure. Since the first portion of the electrically conductive path extends not only on the surface of the electrically conductive portion of the component, but also on a portion of the stack, it also covers the inside wall (at least in the bottom region) of the feedthrough, such that a gapless sealing is achieved.

According to a preferred embodiment, the contact area of the electrically conductive portion with the first portion corresponds to the cross-sectional area of the feedthrough, wherein preferably the cross-sectional area of the feedthrough is smaller than the total surface area of the electrically conductive portion. The cross-sectional area of the feedthrough can be essentially constant; alternatively, in cases with non-constant cross section, the "cross-sectional area of the feedthrough" means the cross-sectional area of the feedthrough at its end facing the electrical component. This may bring the advantage that the whole (lower) extremity of the feedthrough is covered by the first portion.

According to a preferred embodiment, the first portion comprises at least two layer portions extending on at least two different levels, wherein the at least two different levels are separated from each other by at least one electrically insulating layer of the electrically insulating layer structure, wherein preferably the at least two layer portions extending on at least two different levels are interconnected by at least one portion extending transverse, preferably perpendicular, to the planes of the at least two levels. This fingerprint feature may be achieved using the described manufacturing method related to a cheap and reliable panel level construction. Thus, the at least one portion extending transversely may prevent diffusion of material from the at least one electrically insulating layer structure into the electrically conductive path.

According to a preferred embodiment, an electrically conductive layer of the electrically conductive layer structure is provided on an external side of the at least one electrically insulating layer structure, wherein the first portion at least partially covers and/or adheres to the electrically conductive layer. This may bring the advantage of providing an easy to manufacture connection to an exposed surface, additionally having an electrically conductive portion and/or surface extending perpendicular to the stacking direction. This may simplify the design of an electrical connection from the at least one electrically conductive portion to the exposed or the intermediate surface of the component carrier.

According to a preferred embodiment, at least two adjacent feedthroughs of the plurality of feedthroughs are separated by a multilayer wall comprising at least an electrically insulating layer and the electrically conductive layer. This may bring the advantage of imparting additional physical properties, for example CTE, or Youngs Modulus, to the component carrier ensuring high yield production of using the described method.

According to a preferred embodiment, the feedthrough opening in the at least one electrically insulating layer structure and the feedthrough opening provided in the at least one electrically conductive layer (that is adjacent/in contact with said electrically insulating layer structure) have a planar extension defining an undercut below the electrically conductive layer (from the side of said at least one electrically insulating layer structure). This may bring the advantage of providing a good mechanical structure for further electrically insulating layer structure or further electrically conductive layer structures, since the undercut may be configured as an anchor structure. The anchor structure may become entangled with the further electrically insulating layer structure or further electrically conductive layer structures. This undercut can be the footprint of the manufacturing method, for example the result of a laser drilling provided on the electrically conductive layer and the electrically insulating layer structure forming the feedthrough.

According to a preferred embodiment, a layer of the first portion covering and preferably adhering to the electrically conductive portion of the electronic component and a further layer covering and/or adhering to the electrically conductive layer and formed from the same material as the first portion do not form a continuous structure and/or are separated from each other and/or do not merge into each other. This artefact resulting from the provided method may create a further anchor structure for the second portion of the electrically conductive path enabling both, good mechanical integration into the electrically conductive path and good electrically conduction.

According to a preferred embodiment, the electronic component comprises a plurality of electrically conductive portions at its first surface for establishing an electrical connection to the functional portion of the electronic component, wherein a plurality of feedthroughs is formed in the electrically insulating layer structure, said feedthroughs positionally match with the plurality of electrically conductive portions of the electronic component, wherein electrically conductive paths extend from each of the electrically conductive portions of the electronic component through a corresponding feedthrough of the plurality of feedthroughs, wherein the electrically conductive paths each comprise
- a first portion, preferably formed as a layer, said first portion covering at least a portion of the electrically conductive portion of the electronic component, said first portion also covering at least a portion of the stack, preferably at least a portion of the electrically insulating layer structure, and
- a second portion, preferably formed as a layer, that covers the first portion, said second portion being separated from the electrically conductive portion of the electronic component by the first portion.

This may bring the advantage of providing multiple physical and/or electrical connection to a plurality of electrically conductive portion of the electronic component in an easy and reliable way using the described method.

According to a preferred embodiment, the first portion covers the electrically conductive portion of the electronic component and at least a wall portion of the feedthrough toward the electronic component. This may bring the advantage of electrically connecting (i.e. guiding the electronic signal) towards the intended direction and thus may reduce signal losses.

The object is also achieved by a method for manufacturing a component carrier assembly, said component carrier assembly comprising a component carrier and an electronic component, wherein the component carrier comprises a stack, said stack comprising at least one electrically conductive layer structure and electrically insulating layer structures, wherein the electronic component comprises at least one electrically conductive portion at a first surface for establishing an electrical connection to the functional portion of the electronic component, the method comprising the steps of:
(a) embedding the electronic component at least partially, preferably fully, within the component carrier, such that said at least one electrically insulating layer structure covers at least the first surface of the electronic component and at least one feedthrough is formed in the electrically insulating layer structure, said at least one feedthrough positionally matches with the at least one electrically conductive portion of the electronic component,
(b) forming an electrically conductive path that extends from the at least one electrically conductive portion of the electronic component through the feedthrough, wherein step (b) comprises the sub-steps of
   (b1) forming a first portion of the electrically conductive path, preferably as a layer, said first portion covering at least a portion of the electrically conductive portion of the electronic component, said first portion also covering at least a portion of the stack, preferably at least a portion of the electrically insulating layer structure, and
   (b2) forming a second portion of the electrically conductive path, preferably as a layer, that covers the first portion, said second portion being separated from the electrically conductive portion of the electronic component by the first portion,
wherein the first portion is formed from a first material, the second portion is formed from a second material and the electrically conductive portion of the electronic component is formed from a third material, wherein the first material is different to the third material, wherein preferably the first material is different to the second material and different to the third material, wherein the second material and the third material are different from each other.

According to a preferred embodiment, the method is a method for manufacturing an inventive component carrier assembly, particularly according to one of the embodiments described above. The advantages of an inventive component carrier have been discussed above and the arguments are also transferred to the manufacturing method.

According to a preferred embodiment, the at least one feedthrough in the electrically insulating layer structure is formed by material removal, preferably by laser drilling, preferably after the first surface of the electronic component has been covered by said at least one electrically insulating layer structure. Material removal has to care for the resilience of the third material. Particularly, in the case of aluminium as third material laser drilling is the preferred choice, since chemical treatments may cause corrosion. This may bring the advantage of enabling the use of third material, which is prone to decomposition, in particular etching, during wet-chemical manufacturing processes.

According to a preferred embodiment, sub-step (b1) is performed by material deposition, preferably chemical vapour deposition or physical vapour deposition, for example sputtering, and/or wherein sub-step (b2) is performed by material deposition, preferably plating. In such a way a reliable adhesion and thus a good electrical contact may be achieved, particularly of the first material on the third material.

According to a preferred embodiment, an electrically conductive layer, is provided on an external side of the electrically insulating layer structure, wherein preferably the external electrically conductive layer is formed from the second material. This may bring the advantage of good physical, chemical and/or mechanical interaction, since the material of the external electrically conductive layer and the second material may be similar, in particular the same. Furthermore, the manufacturing equipment does not have to be adapted, since similar, in particular the same, material is used during manufacturing resulting in possible higher through put.

According to a preferred embodiment, the method comprises, prior to step (b), the steps of partially covering the electrically conductive layer (provided on an external side of the at least one electrically insulating layer structure) by a mask, preferably a peel off mask, such that the feedthroughs and an area adjacent to the feedthroughs are covered by the mask, and removing the electrically conductive layer in a region not covered by the mask, preferably by etching or laser ablation, and
removing the mask, such that the at least one electrically conductive portion of the electronic component is accessible through the feedthrough.

The use of a removable mask protects the electrically conductive portion of the electronic component (particularly if made from aluminium) on the bottom of the feedthrough(s), also called via(s), during the step of removing the (external) electrically conductive layer.

According to a preferred embodiment, in sub-step (b1) the remaining (external) electrically conductive layer is covered by the first material of the first portion. This measure enhances the coupling of the second portion with the first portion, regarding to both, mechanical stability and electrical coupling. Moreover, the third material is efficiently protected by the first portion and therefore a possible wet chemical treatment step may be enabled without decomposing the third material.

According to a preferred embodiment, the method comprises the step of selectively removing, preferably by etching, electrically conductive material from the external side of the electrically insulating layer structure such that adjacent electrically conductive paths each extending to an electrically conductive portion of the electronic component are electrically separated from each other. This may bring the advantage creating a plurality of electrically feedthroughs laterally distanced from each other, wherein the distance may be smaller than 20 µm, preferably smaller than 15 µm.

According to a preferred embodiment, the method comprises, prior to step (b) and preferably subsequent to step (a), a first step of cleaning the at least one electrically conductive portion of the electronic component,
wherein preferably the first step of cleaning is configured to remove carbon material and/or carbon residues from the at least one electrically conductive portion,
wherein preferably the first step of cleaning comprises a, preferably oxygen-containing, plasma treatment. This may bring the advantage of creating a residue free connection between the electrically conductive path and the first portion and/or between the first portion and the second portion and/or between the first portion or the second portion and the electrically insulating layer structure.

According to a preferred embodiment, the method comprises, prior to step (b) and preferably subsequent to step (a) and preferably subsequent to the first step of cleaning, a second step of cleaning the at least one electrically conductive portion of the electronic component, wherein the second step of cleaning is configured to remove oxides from the at least one electrically conductive portion, wherein preferably the second step of cleaning comprises a, preferably argon, plasma treatment. This may bring the advantage creating a connection between the first portion and the electrically conductive portion been free from foreign material and/or voids. This may result in a highly reliable connection having a good heat spreading ability and/or an electrical signal transport ability.

To provide better understanding of the invention, the invention is explained in more detail with the aid of the following figures.

The following is shown in a strongly simplified, schematic representation:
Fig. 1 an embodiment of an intermediate product with the component being embedded with the within the component carrier;
Fig. 2 an embodiment of an intermediate product with feedthroughs;
Fig. 3 an embodiment of an intermediate product with a mask covering the feedthroughs;
Fig. 4 an embodiment of an intermediate product with removed electrically conductive portion;
Fig. 5 an embodiment of an intermediate product with the mask being removed;
Fig. 6 an embodiment of an intermediate product with applied first portion and second portion of the electrically conductive paths;
Fig. 7 an embodiment of an intermediate product with the feedthroughs being filled with second material;
Fig. 8 an embodiment of an intermediate product with applied mask for forming protrusions of the second portion;
Fig. 9 an embodiment of an intermediate product with removed mask
Fig. 10 an embodiment of an intermediate product after removal of a (electrically conductive) layer resulting from material deposition;
Fig. 11 an embodiment of an intermediate product after removal of a layer resulting from (excess) material of the first portion or first material;
Fig. 12 an embodiment of an inventive component carrier assembly; and
Fig. 13 an embodiment of the feedthrough structure.
Fig. 14 further embodiments.
Fig. 15 further embodiments.
Fig. 16 further embodiments.

As an introduction, it should be noted that in the embodiments described in different ways, identical parts or method steps are indicated with identical reference numbers or identical component designations; at the same time, the disclosures contained in the entire description may be analogously applied to identical parts with identical reference numbers or identical component designations. Moreover, the position indications chosen in the description, such as at the top, at the bottom, laterally, etc. refer to the figure which is directly represented and described; and if a position changes, said position indications are to be applied analogously to the new position.

The embodiments show possible variants; however, it should be noted at this point that the invention is not limited to the variants specifically shown; rather, various combinations of the individual variants are possible as well, and, due to the technical information provided by the present invention, this variation possibility is subject to the skills of the person skilled in the art who works in this technical field.

The scope of protection is determined by the claims. However, the description and the drawings are to be used for construing the claims. Individual features or feature combinations from the different embodiments that are shown and described may per se constitute independent solutions according to the invention. The object underlying the independent solutions according to the invention may be gathered from the description.

Any indications of value ranges in the present description are to be understood as including any and all subranges thereof; for example, the indication 1 to 10 is to be understood as including all subranges, starting out from the lower boundary 1 to the upper boundary 10; i.e. all subranges start with a lower boundary of 1 or greater and stop at an upper boundary of 10 or less, e.g. 1 to 1.7 or 3.2 to 8.1 or 5.5 to 10.

For the sake of good order, it should finally be noted that, for better understanding, some of the facts shown in the figures have been represented unscaled and/or enlarged and/or in reduced size.

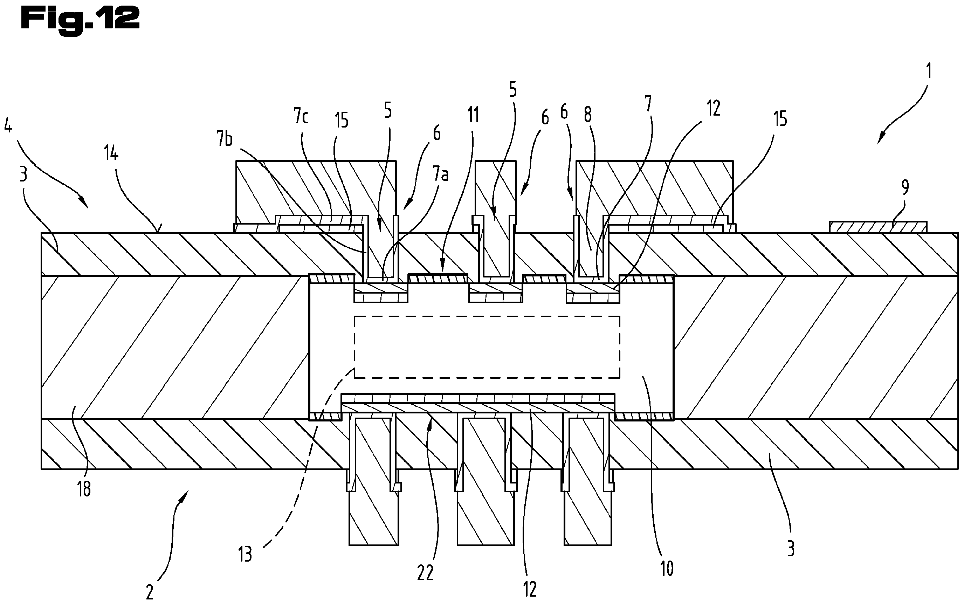

Fig. 12 shows an exemplary embodiment of a component carrier assembly 1.

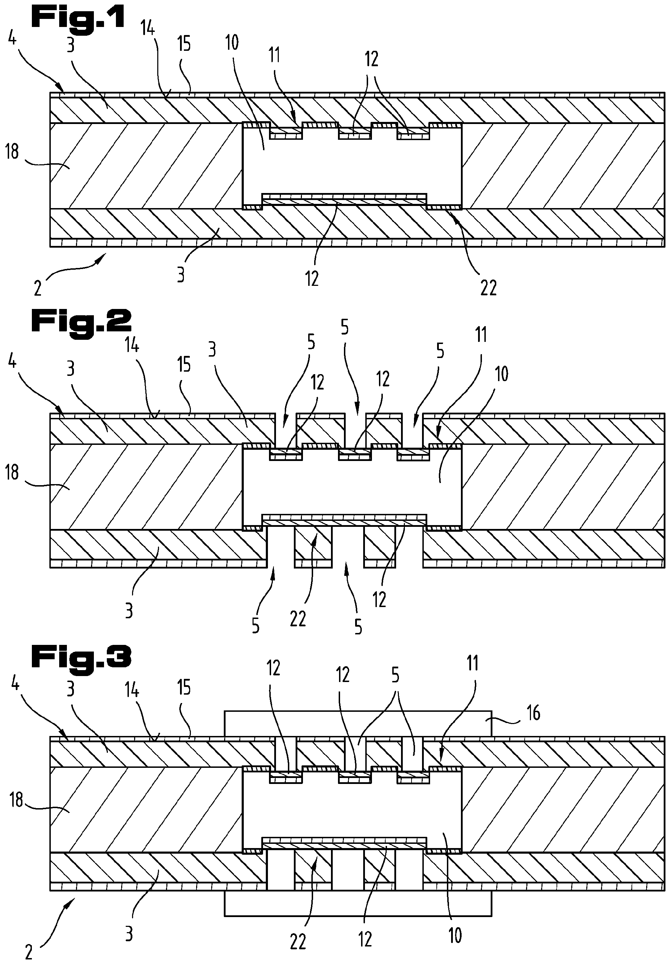

Figs. 1-11 show an exemplary embodiment of manufacturing a component carrier assembly 1.

From Fig. 12 it is apparent, that the component carrier assembly 1 comprises a component carrier 2 and an electronic component 10 at least partially (in the present embodiment fully) embedded within the component carrier 2.

The component carrier 2 comprises a stack 4, said stack 4 comprising at least one electrically conductive layer structure 9 and electrically insulating layer structures 3, wherein at least one electrically insulating layer structure 3 (e.g. in form of a resin sheet) covers at least a first surface 11 of the electronic component 10 and optionally at least a part of at least one electrically conductive portion 12. The electrically conductive layer structure 9 is schematically shown in Fig. 12 and may be e.g. in electrical connection with at least one of the electrical conductive paths 6 or with other components, interfaces or connections.

The electronic component 10 comprises electrically conductive portions 12 (here in the form of pads) at its first surface 11 for establishing an electrical connection to the functional portion 13 of the electronic component 10. Additionally, in the exemplary embodiment the electronic component 10 comprises electrically conductive portions 12 (here in the form of pads) also at its opposed surface for establishing a further electrically connection to the functional portion 13 of the electronic component 10 and/or for heat distribution. The electrically conductive portions 12 may be the component pad or a layer overlapping said pad, preferably preventing exposure of said component pad.

Feedthroughs 5 are formed in the electrically insulating layer structure 3, each feedthrough 5 positionally matches with an electrically conductive portion 12 of the electronic component 10. Positionally matching means, that there is at least a partial overlap of the feedthrough (cross-section) with the electrically conductive portion 12. Deviations from a perfect or complete overlap also fall under the term "positionally matching", said deviations allowing that the electrically conductive portion 12 may be electrically contacted via the feedthrough (alternatively it may be understood, at least one feedthrough may be positioned in a way that more than 1% of the area which should be in contact with the electrically conductive portion 12 is not in direct contact due to some deviation from a complete overlap). An electrically conductive path 6 (that may be part of or in electrical connection with the at least one electrically conductive layer structure 9) extends from an electrically conductive portion 12 of the electronic component 10 through a feedthrough 5.

A first portion 7 (preferably formed as a layer) of the electrically conductive path 6, covers at least a portion of the electrically conductive portion 12 of the electronic component 10, such that an electrical connection is established between the electrically conductive portion 12 and the electrically conductive path 6. Preferably, the first portion 7 of the electrically conductive path 6 may fully cover the conductive portion 12 of the electronic component 10. Said first portion 7 also covers at least a portion of the stack 4. In the present embodiment, said first portion covers (is in direct touch with the) at least a portion of the electrically insulating layer structure 3, in particular a portion forming a sidewall of the feedthrough 5. This may be - for example - realized in that the first portion 7 covers the electrically conductive portion 12 of the electronic component 10 and at least a wall portion of the feedthrough 5 towards the electronic component 10.

As can be seen from the figs. the first portion 7 extends at least partially, preferably fully, through the feedthrough 5, preferably to the external side of the component carrier 2. It is preferred if the first portion 7 forms a - partial or complete - lining of the interior wall of the feedthrough 5. Additionally, or alternatively, the first portion 7 may cover an external surface of the electrically insulation layer structure 3 at least in an area of the feedthrough 5 (see fig. 12). The at least a (horizontal and/or vertical) portion of the first portion 7 may be exposed to the outer surface of the component carrier (assembly).

A second portion 8 (preferably formed as a layer) of the electrically conductive path 6 covers (is in direct touch with) the first portion 7, such that an electrical connection is established between first portion 7 and second portion 2. The second portion 8 is separated from the electrically conductive portion 12 of the electronic component 10 by the first portion 7. Alternatively, at least a portion of the second portion 8 may be in direct contact with the electrically conductive portion 12 of the electronic component 10. It is preferred, if the second portion 7 extends through the feedthrough 5, preferably to the external side of the component carrier 2 (see fig. 12).

According to a preferred embodiment also the second surface 22 of the component 10 (the second surface 22 being opposed to the first surface 11) may be also covered by an electrically insulating layer structure 3 (preferably of the same type and/or dimension as the electrically insulating layer structure 3 covering the first surface 11, or alternatively the bottom electrically insulating layer structure may be different from the top one, differing in at least one of the following features: composition of the resin, composition of the included filler material, amount of the filler material, shape of the filler material, size of the layer). Feedthrough(s) 5 and electrically conductive path(s) 6 may be provided in the same or similar way extending from the electrically conductive portion(s) 12 located at the second surface 22 of component 10 (Fig. 12).

The first portion 7 is formed from a first material (preferably comprising titanium), the second portion 8 is formed from a second material (preferably comprising copper) and the electrically conductive portion 12 of the electronic component 10 is formed from a third material (preferably comprising aluminium), wherein the first material is different to the third material, wherein preferably the first material is different to the second material and the third material, wherein preferably the second material and the third material are different from each other.

The first material may be or comprise an element selected from Sc, Y, La, Ti, Zr, Hf, V, Nb, Ta, Cr, Mo, W, Mn, Tc and Re, wherein preferably the first material is or comprises Ti, Cr, or W. Additionally and/or alternatively, the first material may comprise an element selected from Na, K, Ca, Mg, Fe, Co, Ni, Cu, Zn, Ru, Rh, Pd, Ag, Cd, Os, Ir, Pt, Au, Hg, Al, Si.

The second material may be or comprise an element selected from Sc, Ti, V, Cr, Mn, Fe, Co, Ni, Cu, Zn, Ru, Rh, Pd, Ag, Cd, Os, Ir, Pt, Au, Hg, preferably Ti, Cr, Ni, Cu, Pd, Ag, Ir, Au, wherein preferably the second material is or comprises copper. Additionally or alternatively, the second material may be or comprise an element selected from Na, K, Ca, Mg, Al, Sn, Pb.

The third material is preferably different from copper and/or free of copper. The third material may be or comprise an element selected from Sc, Ti, V, Cr, Mn, Fe, Co, Ni, Zn, Al, Ga, In, Tl, Sn, or Pb. The third material may be carbon, such as graphene, or electrically conductive polymer, such as PEDOT, wherein preferably the third material is or comprises aluminium. Additionally or alternatively, the third material may be or comprise an element selected from Na, K, Ca, Mg, Cr, Ni, Pd, Pt, Au, Ag.

As can be seen from Fig. 12 the at least one feedthrough 5 and the electrically conductive path 6 extend to an external side of the component carrier 2. Thereby preferably, exposing at least one surface to the external side of the component carrier 2.

In an embodiment the surface of the first portion 7 facing the electrically conductive portion 12 of the electronic component 10 defines a protecting surface interface, said surface interface being free of carbon and/or free of oxygen and/or free of at least oxides based on atoms of the third material, preferably free of any oxides. Alternatively, the protecting surface interface comprises a content of carbon and/or oxygen that is smaller than 1000 ppm. Additionally or alternatively, said surface interface being free of sulphur and/or nitrogen and/or phosphorous.

In the following preferred embodiments with respect to the first portion are described:
The contact area of the electrically conductive portion 12 with the first portion 7 may correspond to at least 60%, preferably to at least 80%, of the total surface area of the electrically conductive portion 12. Additionally or alternatively, the contact area of the electrically conductive portion 12 with the first portion 7 may be in the range between 30% to 60%. If the contact area is less than 100% of the total surface area of the electrically conductive portion 12, it is preferred that the remaining area of the electrically conductive portion 12 is covered by the electrically insulating layer structure 3. Alternatively, the remaining area of the electrically conductive portion 12 is covered by a further electrically insulating material, for example glass or ceramic.

As an example, the contact area of the electrically conductive portion 12 with the first portion 7 may correspond to the cross-sectional area of the feedthrough 5, wherein preferably the cross-sectional area of the feedthrough 5 is smaller than the total surface area of the electrically conductive portion 12. Alternatively, the cross-sectional area of the feedthrough 5 and the total surface area of the electrically conductive portion 12 may be of the same size or the cross-sectional area of the feedthrough 5 may even be larger than the total surface area of the electrically conductive portion 12.

As can be seen from the preferred embodiment of fig. 12, the first portion 7 may comprise at least two layer portions 7a, 7c extending on at least two different levels, wherein the at least two different levels are separated from each other by at least one electrically insulating layer of the electrically insulating layer structure 3.

As can be also seen from fig. 12, the at least two layer portions 7a, 7c may be interconnected by at least one portion 7b extending transverse, preferably perpendicular (vertical), to the planes of the at least two levels.

It is also possible that an electrically conductive layer 15 is provided on an external side 14 of the electrically insulating layer structure 3. In that case, the first portion 7 may at least partially cover and/or adhere to said electrically conductive layer 15. Alternatively, a further electrically insulating layer may be provided on an external side 14 of the electrically insulating layer structure 3. In that case, the first portion 7 may at least partially cover and/or adhere to the further electrically insulating layer. Alternatively, a further electrically insulating layer may be removed before applying (a layer of) the first portion 7.

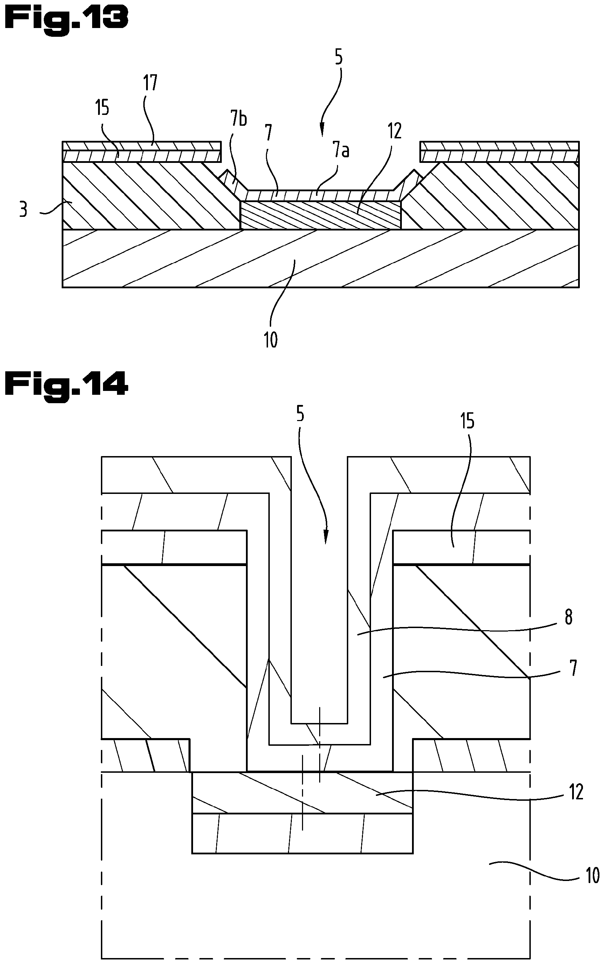

According to a further embodiment at least two adjacent feedthroughs 5 of the plurality of feedthroughs 5 may be separated by a multilayer wall comprising at least an external insulating layer and the external electrically conductive layer 15. Alternatively, at least two adjacent feedthroughs 5 of the plurality of feedthroughs 5 may be separated by a layer comprising at least one electrically insulating layer structure. The feedthrough opening in the electrically insulating layer structure and (optionally) the feedthrough opening provided in said electrically conductive layer 15 (that is in contact/adhering said electrically insulating layer structure) may each have a planar extension defining an undercut below the external electrically conductive layer 15 (see Fig. 13).

Fig. 12 shows such an embodiment, with the first portion 7 extending as follows: it covers the electrically conductive portion 12 (forming the bottom of the feedthrough 5) and a lower part of the inner wall of the (tapered) feedthrough 5. With other words: also in this embodiment the first portion 7 covers at least a portion of the electrically conductive portion 12 of the electronic component 10 and at least a portion of the stack 4 (here: a portion of the electrically insulating layer structure 3 forming the inner wall of feedthrough 5). Furthermore, the first portion 7 may extend beyond the thickness of the stack 2. Alternatively, the first portion 7 may be part of the stack.

According to a further embodiment a layer 7c of the first portion 7 covering and preferably adhering to the electrically conductive portion 12 of the electronic component 10 and a further layer 17 covering and/or adhering to the external portion of the electrically conductive layer 15 and formed from the same material as the first portion 7 do not form a continuous structure and/or are separated from each other and/or do not merge into each other.

In the following further optional features are described:
The stack 4 or component carrier 2 may comprise further (electrically conductive and/or electrically insulating) layers to create a multi-layer stack.

An exposed or outer surface of the component carrier 2 or component carrier assembly 1 may be provided (in a finishing step) with a "surface finish" or a finishing layer, wherein preferably a solder resist and/or a tin and/or gold layer (or similar) is applied to that outer surface.

Core 18 may be a multilayer core and or a glass or ceramic core. Core 18 may, but does not have to be a core layer (a non-fully cured layer may be possible).

In the following preferred dimensions of the layers or structure elements of the component carrier (assembly) are listed:
Core 18 may have a thickness of 50 µm - 600 µm, preferably 60µm - 250 µm.

The electrically conductive portion 12 of the electronic component 10 may have a thickness of 0,5µm - 10 µm, preferably 1 µm - 5 µm.

The electrically insulating layer structure 3 may have a thickness of 5 µm - 250 µm, preferably 10 µm - 80 µm.

The electrically conductive layer 15 may have a thickness of 0,5 µm - 20 µm, preferably 1 µm - 10 µm.

The (layer of the) first portion 7 may have a thickness of 20 nm - 2 µm, preferably 50 nm - 800 nm.

The feedthrough 5 may have a diameter of 2 µm - 150 µm, preferably 10 µm -70 µm.

The electrically conductive portion 12 of the electronic component 10 may protrude out of the component surface (first surface 11 or second surface 12), may be flush with the component surface or may be indented (as shown in fig 12).

The through connection may connect the external electrically conductive layer structure and/or different metal layers with each other (plated mechanically /laser drilled through via).

In a preferred embodiment shown in fig. 14 the feedthrough 5 may be acentric (off-center) with respect to the corresponding electrically conductive portion 12 (i.e. the electrically conductive portion 12 positionally matching with said feedthrough 5); or with other words: the center of the cross-sectional area of the feedthrough 5 is not aligned with the center of the total surface area of the electrically conductive portion 12 (positionally matching with said feedthrough).

In the following an exemplary method for manufacturing a component carrier assembly 1 is described with respect to the figs. 1 - 11. The method may be adapted for manufacturing a component carrier assembly 1 according to the invention including its embodiments.

According to a step (a) the electronic component 10 is at least partially (in the present embodiment fully) embedded within the component carrier 2, such that said at least one electrically insulating layer structure 3 (preferably having a thickness between 10µm and 50µm), preferably a resin sheet, covers at least the first surface 11 of the electronic component 10. Fig. 1 shows a possible result in which a core 18 (on the same level) with the embedded component 10 is sandwiched between (upper and lower) electrically insulating layer structures 3. The core 18 and/or the component 10 may have a thickness (i.e. extension in vertical direction) between 30 and 200µm, preferably between 30 and 100µm. Alternatively, the electronic component 10 may be thinner than the core (layer) 18. Usually, the initial cavity (in which the electronic component 10 is embedded) is larger in its main extensions (x, y; i.e. parallel to the planes P). The gaps (between the cavity and the component) are filled up with additional (filler) material, preferably after the electronic component 10 has been placed inside the cavity.

On the top and/or bottom of the intermediate product an electrically conductive layer 15 (preferably having a thickness between 1µm and 5µm), preferably a foil, such as a Cu foil, may be provided. The electrically conductive layer 15 may be formed from the second material. Alternatively, of course, the electric conductive layer 15 may be formed from a material different to the second material.

After having provided an intermediate product with embedded component 10, at least one feedthrough 5 is formed in the electrically insulating layer structure 3, said at least one feedthrough 5 positionally matches with the at least one electrically conductive portion 12 of the electronic component 10 (Fig. 2). In the present embodiment, a feedthrough 5 for each electrically conductive portion 12 of the component 10 is formed. Forming the feedthrough(s) 5 may be done by material removal, preferably by laser drilling. Alternatively, the material removal for forming the feedthrough(s) 5 may be done by plasma etching, preferably by a RIE anistropic plasma etching process. Preferably, the material removal process may completely remove material in the portion(s), where the feedthrough(s) shall be formed. Thereby at least a portion of the electrically conductive layer 15 and at least a portion of the electrically insulating layer structure 3 may be removed in order to expose the at least one electrically conductive portion 12.

In the case an electrically conductive layer 15 is provided on the top and/or bottom of the intermediate product, material of the layer 15 is selectively removed at locations positionally matching with the at least one electrically conductive portion 12 or the feedthroughs 5 (Fig. 2). Selective removal may be done by using a laser beam, particularly an UV laser beam. In case of using a laser the shape as shown in fig. 13 can be obtained, especially the tapered shape of the feedthrough 5. Alternatively selective removal may be done by applying a mask, preferably from photoresist, and subsequent etching. Optionally, after the material removal process, a cleaning or washing process may be applied, for example using a cleaning fluid, i.e. water or an organic solvent.

In an alternative embodiment, the electrically conductive portions 12 may be selectively covered with a material, acting as a mask for a subsequent step of applying an electrically insulating layer structure 3 by material deposition. The material (such as a photoresist), acting as a mask, will be removed after the electrically insulating layer structure 3 has been applied. The remaining openings in the electrically insulating layer structure 3 then form the feedthroughs 5.

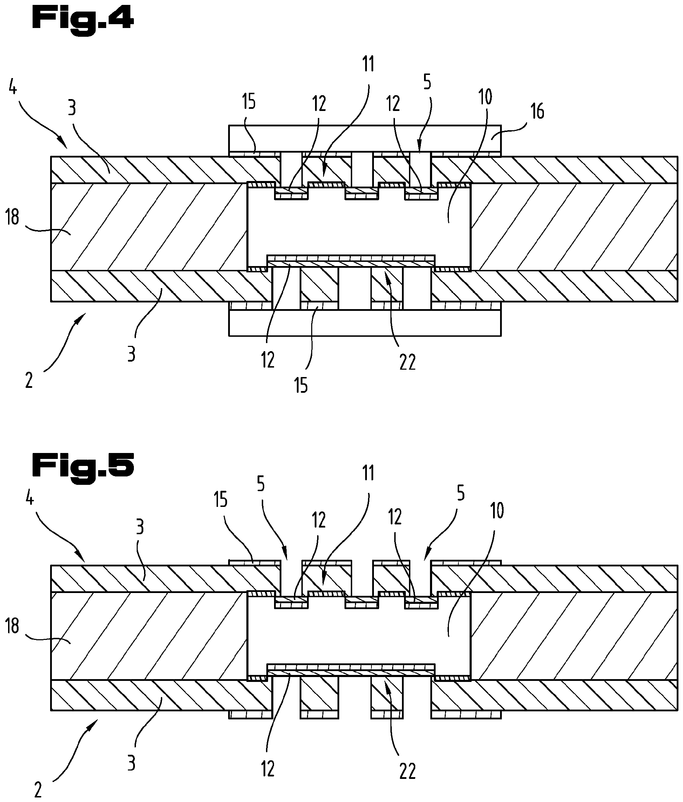

The method may comprise, subsequent to step (a) and prior to step (b), the steps of: partially covering the electrically conductive layer 15 by a mask, preferably a peel off mask 16, such that the feedthroughs 5 and an area adjacent to the feedthroughs 5 are covered by the mask (Fig. 3), and removing the exposed electrically conductive layer 15 in a region not covered by the mask (Fig. 4), preferably by etching or laser ablation, and removing the mask 16, such that the at least one electrically conductive portion 12 of the electronic component 10 is accessible through the feedthrough 5 (Fig. 5). The use of a mask protects the electrically conductive portion 12 (particularly if made from aluminium) on the bottom of the feedthrough(s) 5, also called via(s).

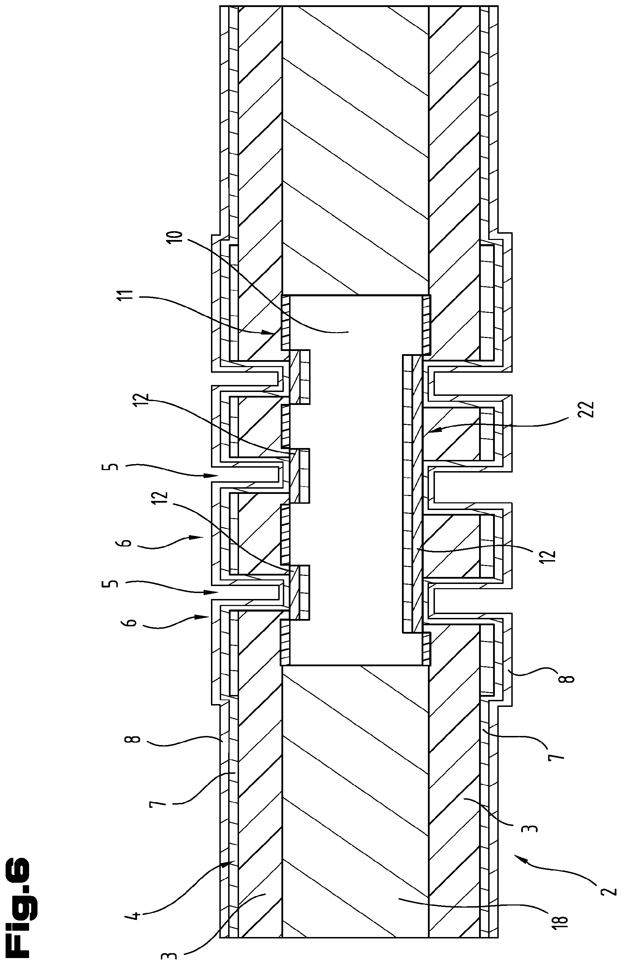

According to a step (b) an electrically conductive path (6) that extends from the at least one electrically conductive portion 12 of the electronic component 10 through the feedthrough 5 is formed. Step (b) comprises the sub-steps (b1) and (b2):
According to sub-step (b1) a first portion 7 of the electrically conductive path 6, preferably as a layer, is formed, said first portion 7 covering at least a portion of the electrically conductive portion 12 of the electronic component 10 (Fig. 6). Sais first portion 7 also covers at least a portion of the stack 4, preferably at least a portion of the electrically insulating layer structure 3 (covering the first surface 11). Sub-step (b1) may be performed by material deposition, preferably chemical vapour deposition or physical vapour deposition, for example sputtering. According to an embodiment, in sub-step (b1) the remaining electrically conductive layer 15 (i.e. that after the removal of the mask 16) may be covered by the first material of the first portion 11. Also the sidewall of electrically insulating layer structure 3 may be covered by the first material. As already mentioned above the first portion 7 may be formed as a layer, preferably having a thickness of 20 nm - 2 µm, more preferably 50 nm - 800 nm.

According to sub-step (b2) a second portion 8 of the electrically conductive path 6, preferably as a layer, is formed, said second portion 8 covering the first portion 7 (Fig. 6). Said second portion 8 is separated from the electrically conductive portion 12 of the electronic component 10 by the first portion 7. Sub-step (b2) may be performed by material deposition, preferably plating, or electroless plating.

As already mentioned, the first portion 7 is formed from a first material, the second portion 8 is formed from a second material and the electrically conductive portion 12 of the electronic component 10 is formed from a third material, wherein the first material is different to the third material, wherein preferably the first material is different to the second material and the third material, wherein preferably the second material and the third material are different from each other.

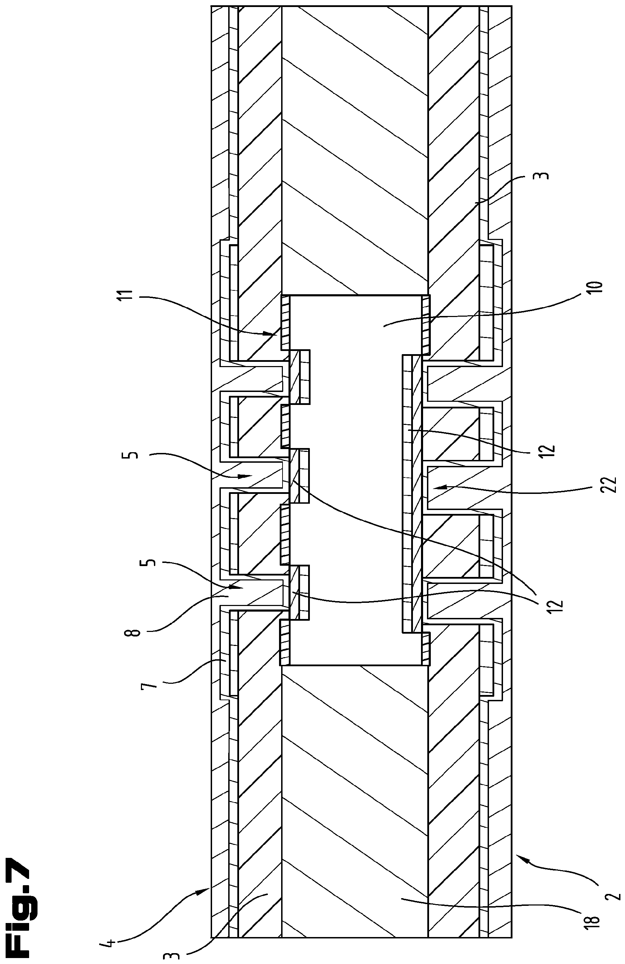

Fig. 7 shows an alternative or additional step, in which the feedthroughs 5 are completely filled with the second material (second portion 8). This may preferably be done by plating, preferably electroless plating and/or (with an additional) electrochemical plating.

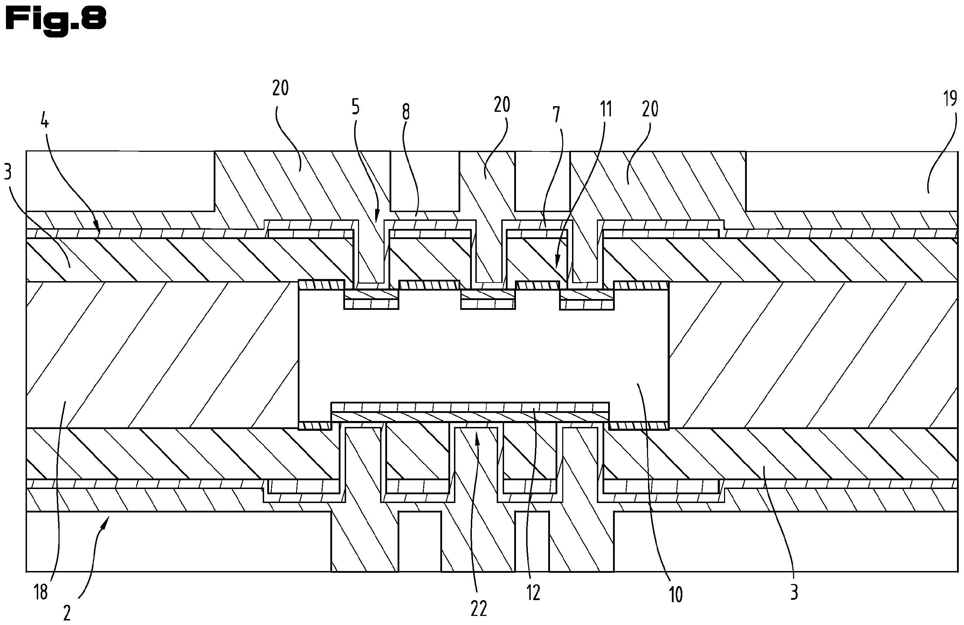

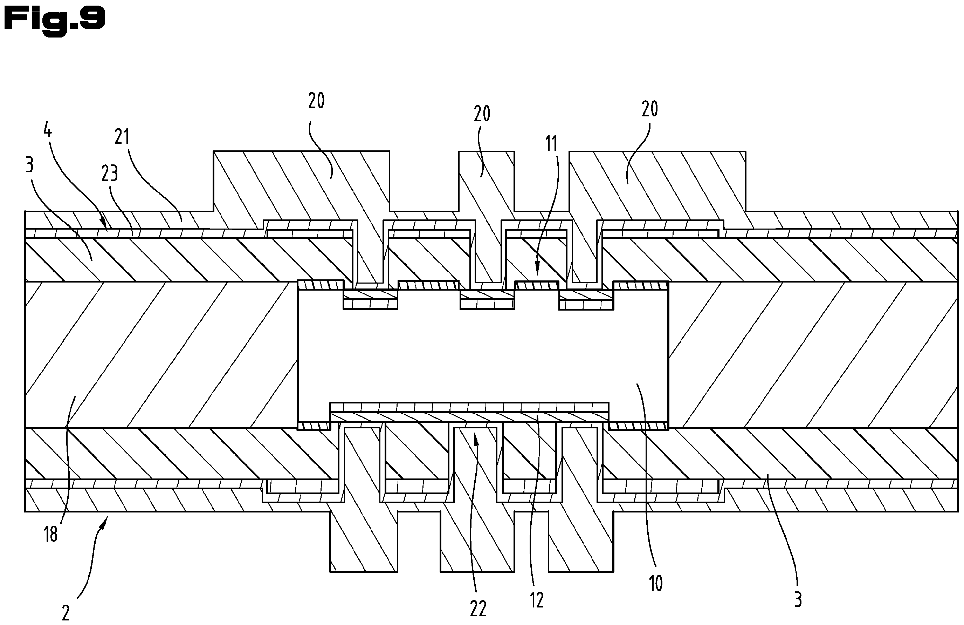

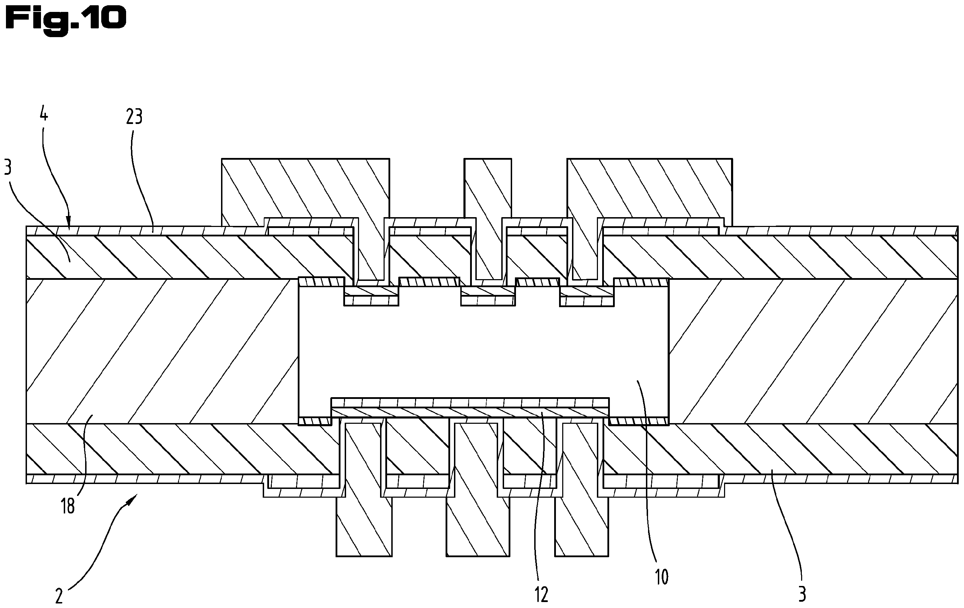

Fig. 8 also shows an alternative or additional step, in which the second portion 8 is formed with protrusions 20 to extend (in the end product of Fig. 12) beyond the surface of the electrically insulating structure 3. This may be done by applying a mask 19, preferably by applying photoresist material (e.g. by lamination) with subsequent developing, and subsequent material deposition, preferably by plating (e.g. Cu). In a next step the mask 19 may be removed (e.g. by photoresist stripping) and an intermediate product according to Fig. 9 is achieved. In a subsequent step a (electrically conductive) layer 21, resulting from that material deposition, may be removed, preferably by etching (e.g. Cu flash etching, or a plasma process) and an intermediate product according to Fig. 10 is achieved. In a further step a (exposed) conductive layer structure 23, resulting from (excess) material of the first portion or first material may be removed, preferably by etching (e.g. Ti etching, or a further plasma process) and an end product according to Fig. 12 is achieved.

In order to generalize the steps of above embodiment, the method may comprise the step of selectively removing, preferably by etching, or a plasma process, electrically conductive material from the external side of the electrically insulating layer structure 3 such that adjacent electrically conductive paths 6 each extending to an electrically conductive portion 12 of the electronic component 10 are electrically separated from each other (Fig. 12).

It is preferred if the method comprises, prior to step (b) and preferably subsequent to step (a), a first step of cleaning the at least one electrically conductive portion 12 of the electronic component 10. The first step of cleaning may be configured to remove carbon material and/or carbon residues from the at least one electrically conductive portion 12. The first step of cleaning may comprise a, preferably oxygen-containing, plasma treatment.

It is further preferred if the method comprises, prior to step (b) and preferably subsequent to step (a) and preferably subsequent to the first step of cleaning, a second step of cleaning the at least one electrically conductive portion 12 of the electronic component 10, wherein the second step of cleaning is configured to remove oxides from the at least one electrically conductive portion 12, wherein preferably the second step of cleaning comprises a, preferably argon, plasma treatment.

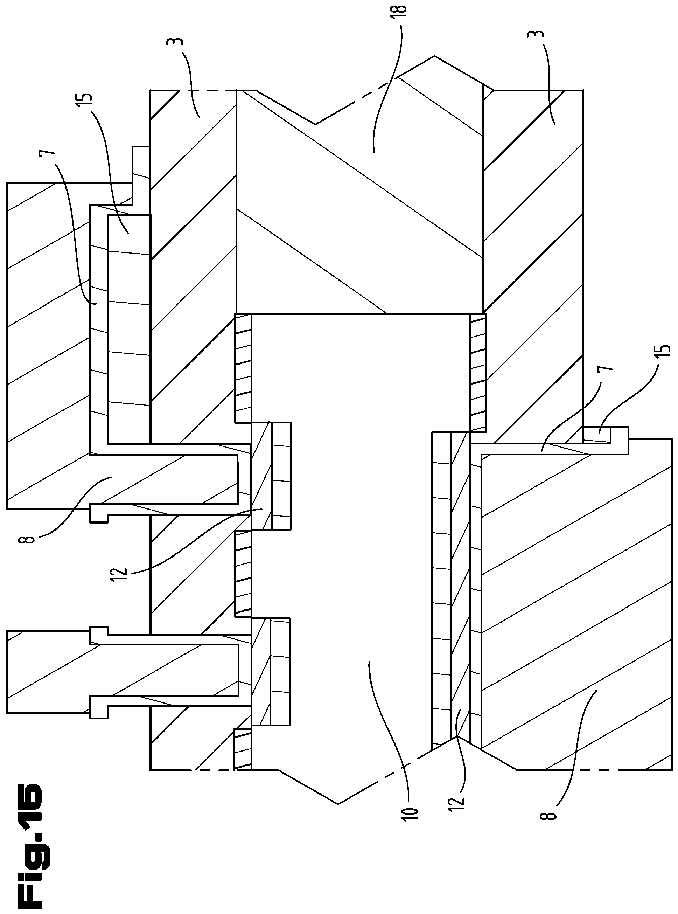

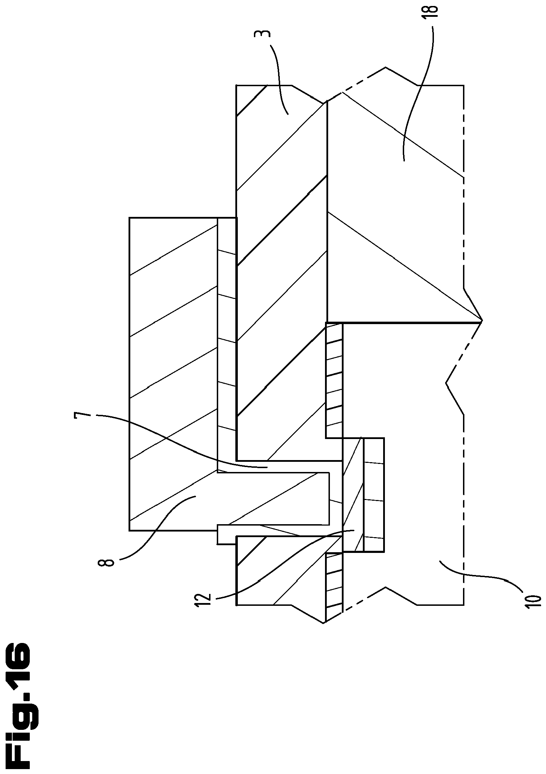

Finally, figs. 15 and 16 show some additional details of a preferred embodiment of a component carrier assembly. The features shown there and described below may be fingerprints of the method used.

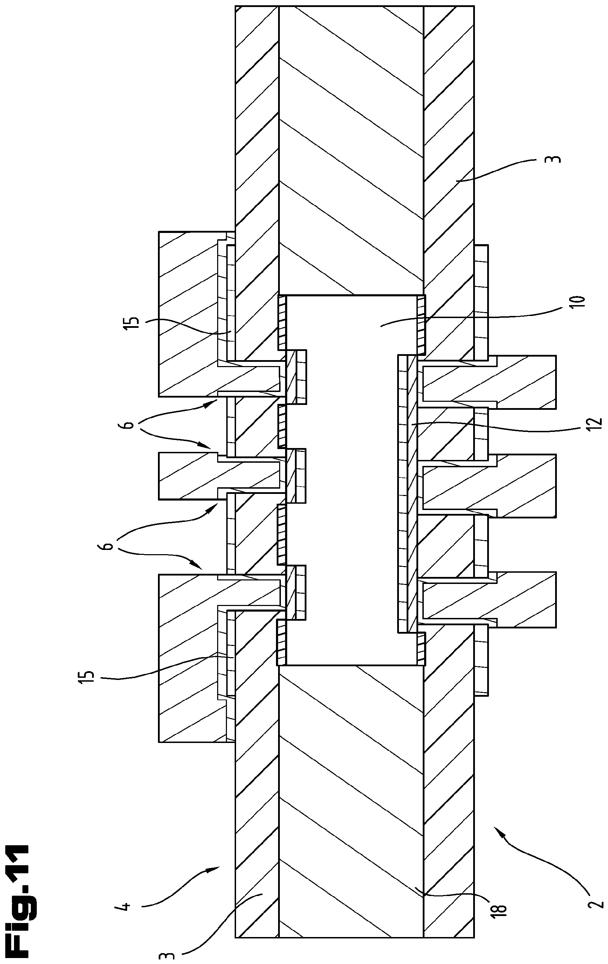

The contacting structure at the top right in fig. 15 has on its left side the following structure: the side wall of feedthrough 5 is not vertically flush with the left end of the first portion 7. Below that end of the first portion 7 (e.g. titantium layer) the layer 15 (still visible in Fig. 11; e.g. copper layer) has been removed. Due to this removal a kind of pocket is created between the end of first portion 7 and electrically insulating layer structure 3. Moreover, the end of first portion 7 extends laterally beyond the second portion 8.

The contacting structure at the top right in fig. 15 has on its right side the following structure: the first portion 7 extends laterally beyond the side wall of the feedthrough 5 and even beyond the layer 15 and beyond the second portion 8. Moreover, it can be seen, that the first portion 7 covers the layer 15 on its top and its lateral sides. The right end of the first portion 7 may even come into contact with the electrically insulating layer structure 3. In the embodiment of fig. 15 both (left and right) ends of the first portion 7 are exposed.

The contacting structure at the bottom in fig. 15 has the following structure: The end of the first portion 7 (e.g. titanium) and a remaining portion of layer 15 (e.g. copper) are vertically flush, however the second portion 8 is more etched and therefore the end of the first portion 7 extends laterally beyond the second portion 8.

The contacting structures described with respect to the figs. 15 and 16 may be related to three different etching steps (etching the second portion 8, etching the first portion 7, etching the layer 15). Complex flow mechanics during etching may etch portions with a higher etching degree /amount compared to other portions. Therefor also this pocket (described above with respect to fig. 15) may be created.

As can be seen as layers are fully etched regarding their thickness direction.

The sidewalls of those structures are drawn vertically straight in the embodiment shown, however, alternatively, the side walls may also have an inclined or tapered or convex or concave shaped portion or may be of irregular shape.

All of these variants may be realized - in combination or individually - in an inventive component carrier assembly. These contacting structures may create an anchor structure and may bring the advantage of good mechanical /physical /chemical interaction with further applied (electrically insulating) layer structures.

Finally, fig. 16 shows a variant without a layer 15 in the final product. In that case the first portion 7 may directly cover the electrically insulating layer structure 3.

### List of references

| | | | |
|---|---|---|---|
| 1 | component carrier assembly | 22 | second surface |
| 2 | component carrier | 23 | layer |
| 3 | electrically insulating layer structure | | |
| 4 | stack | | |
| 5 | feedthrough | | |
| 6 | electrically conductive path | | |
| 7 | first portion | | |
| 7a | layer portion | | |
| 7b | (layer) portion | | |
| 7c | layer portion | | |
| 8 | second portion | | |
| 9 | electrically conductive layer structure | | |
| 10 | electronic component | | |
| 11 | first surface of the electronic component 10 | | |
| 12 | electrically conductive portion of the electronic component 10 | | |
| 13 | functional portion of the electronic component 10 | | |
| 14 | external side of the electrically insulating layer structure 3 | | |
| 15 | electrically conductive layer | | |
| 16 | mask | | |
| 17 | further layer | | |
| 18 | core | | |
| 19 | mask | | |
| 20 | protrusion | | |
| 21 | layer resulting from material deposition | | |

## Claims

1. A component carrier assembly (1) comprising:
- a component carrier (2), and
- an electronic component (10) at least partially, preferably fully, embedded within the component carrier (2),
wherein the component carrier (2) comprises a stack (4), said stack (4) comprising at least one electrically conductive layer structure (9) and electrically insulating layer structures (3),
wherein at least one electrically insulating layer structure (3) covers at least a first surface (11) of the electronic component (10),
wherein the electronic component (10) comprises at least one electrically conductive portion (12), preferably a plurality of electrically conductive portions (12), at its first surface (11) for establishing an electrical connection to the functional portion (13) of the electronic component (10),
wherein at least one feedthrough (5) is formed in the electrically insulating layer structure (3), said at least one feedthrough (5) positionally matches with the at least one electrically conductive portion (12) of the electronic component (10),
wherein an electrically conductive path (6) extends from the at least one electrically conductive portion (12) of the electronic component (10) through the feedthrough (5), wherein the electrically conductive path (6) comprises
- a first portion (7), preferably formed as a layer, said first portion (7) covering at least a portion of the electrically conductive portion (12) of the electronic component (10), said first portion (7) also covering at least a portion of the stack (4), preferably at least a portion of the electrically insulating layer structure (3), and
- a second portion (8), preferably formed as a layer, that covers the first portion (7), said second portion (8) being separated from the electrically conductive portion (12) of the electronic component (10) by the first portion (7),
wherein the first portion (7) is formed from a first material, the second portion (8) is formed from a second material and the electrically conductive portion (12) of the electronic component (10) is formed from a third material, wherein the first material is different to the third material, wherein preferably the first material is different to the second material and different to the third material, wherein preferably the second material and the third material are different from each other.

2. A component carrier according to claim 1, wherein the at least one feedthrough (5) and the electrically conductive path (6) extend to an external side of the component carrier (2) and/or to an electrically conductive layer structure (9).

3. A component carrier according to one of the preceding claims, wherein the first portion (7) extends at least partially, preferably fully, through the feedthrough (5), preferably to the external side of the component carrier (2) and/or to one of the main surfaces of the layer structure (3, 9) composing the stack (4) of the component carrier (2), wherein preferably the first portion (7) forms a - partial or complete - lining of the interior wall of the feedthrough (5),
and/or wherein the second portion (7) extends through the feedthrough (5), preferably to the external side of the component carrier (2) and/or to one of the main surfaces of the layer structure (3, 9) composing the stack (4) of the component carrier (2).

4. A component carrier according to one of the preceding claims, wherein the first portion (7) covers an external surface of the electrically insulation layer structure (3) at least in an area of the feedthrough (5).

5. A component carrier according to one of the preceding claims, wherein the first material is or comprises at least one element selected from the third to the seventh group of the periodic table, wherein preferably the first material is or comprises titanium and/or Chromium and/or Tungsten.

6. A component carrier according to one of the preceding claims, wherein the second material is or comprises at least one element selected from the third to the twelfth group of the periodic table, wherein preferably the second material is or comprises copper.

7. A component carrier according to one of the preceding claims, wherein the third material is different from copper and/or free of copper and/or wherein the third material is or comprises an element selected from Sc, Ti, V, Cr, Mn, Fe, Co, Ni, Zn, Al, Ga, In, Tl, Sn, Pb or wherein the third material is carbon, such as graphene, or electrically conductive polymer, such as PEDOT, wherein preferably the third material is or comprises aluminium.

8. A component carrier according to one of the preceding claims, wherein the surface of the first portion (7) facing the electrically conductive portion (12) of the electronic component (10) defines a protecting surface interface, said surface interface being free of carbon and/or free of oxygen and/or free of at least oxides based on atoms of the third material, preferably free of any oxides.

9. A component carrier according to one of the preceding claims, wherein the first portion (7) comprises at least two layer portions (7a, 7c) extending on at least two different levels, wherein the at least two different levels are separated from each other by at least one electrically insulating layer of the electrically insulating layer structure (3), wherein preferably the at least two layer portions (7a, 7c) extending on at least two different levels are interconnected by at least one portion (7b) extending transverse, preferably perpendicular, to the planes of the at least two levels.

10. A component carrier according to one of the preceding claims, wherein an electrically conductive layer (15) of the electrically conductive layer structure is provided on an external side (14) of the at least one electrically insulating layer structure (3), wherein the first portion (7) at least partially covers and/or adheres to the external electrically conductive layer (15).

11. A component carrier according to one of the preceding claims, wherein the feedthrough opening in the at least one electrically insulating layer structure and the feedthrough opening provided in the at least one electrically conductive layer (15) provided on an external side (14) of the at least one electrically insulating layer structure (3) have a planar extension defining an undercut below said electrically conductive layer (15).

12. A component carrier according to one of the preceding claims, wherein a layer (7a) of the first portion (7) covering and preferably adhering to the electrically conductive portion (12) of the electronic component (10) and a further layer (17) covering and/or adhering to the electrically conductive layer (15) and formed from the same material as the first portion (7) do not form a continuous structure and/or are separated from each other and/or do not merge into each other.

13. A method for manufacturing a component carrier assembly (1),
said component carrier assembly (1) comprising a component carrier (2) and an electronic component (10), wherein the component carrier (2) comprises a stack (4), said stack (4) comprising at least one electrically conductive layer structure and electrically insulating layer structures (3), wherein the electronic component (10) comprises at least one electrically conductive portion (12) at a first surface (11) for establishing an electrical connection to the functional portion (13) of the electronic component (10), the method comprising the steps of:
(a) embedding the electronic component (10) at least partially, preferably fully, within the component carrier (2), such that said at least one electrically insulating layer structure (3) covers at least the first surface (11) of the electronic component (10) and at least one feedthrough (5) is formed in the electrically insulating layer structure (3), said at least one feedthrough (5) positionally matches with the at least one electrically conductive portion (12) of the electronic component (10),
(b) forming an electrically conductive path (6) that extends from the at least one electrically conductive portion (12) of the electronic component (10) through the feedthrough (5), wherein step (b) comprises the sub-steps of
(b1) forming a first portion (7) of the electrically conductive path (6), preferably as a layer, said first portion (7) covering at least a portion of the electrically conductive portion (12) of the electronic component (10), said first portion (7) also covering at least a portion of the stack (4), preferably at least a portion of the electrically insulating layer structure (3), and
(b2) forming a second portion (8) of the electrically conductive path (6), preferably as a layer, that covers the first portion (7), said second portion (8) being separated from the electrically conductive portion (12) of the electronic component (10) by the first portion (7),
wherein the first portion (7) is formed from a first material, the second portion (8) is formed from a second material and the electrically conductive portion (12) of the electronic component (10) is formed from a third material, wherein the first material is different to the third material, wherein preferably the first material is different to the second material and different to the third material, wherein preferably the second material and the third material are different from each other,
wherein preferably the method is a method for manufacturing a component carrier assembly (1) according to one of the claims 1 to 12.

14. A method according to claim 13, wherein an electrically conductive layer (15) is provided on an external side of the electrically insulating layer structure (3), wherein preferably the electrically conductive layer (15) is formed from the second material,
wherein preferably the method comprises, prior to step (b), the steps of partially covering the electrically conductive layer (15) by a mask (16), preferably a peel off mask, such that the feedthroughs (5) and an area adjacent to the feedthroughs (5) are covered by the mask, and
removing the electrically conductive layer (15) in a region not covered by the mask (16), preferably by etching, and
removing the mask (16), such that the at least one electrically conductive portion (12) of the electronic component (10) is accessible through the feedthrough (5).

15. A method according to claim 13 or 14, wherein the method comprises, prior to step (b) and preferably subsequent to step (a), a first step of cleaning the at least one electrically conductive portion (12) of the electronic component (10),
wherein preferably the first step of cleaning is configured to remove carbon material and/or carbon residues from the at least one electrically conductive portion (12), wherein preferably the first step of cleaning comprises a, preferably oxygen-containing, plasma treatment,
and/or wherein the method comprises, prior to step (b) and preferably subsequent to step (a) and preferably subsequent to the first step of cleaning, a second step of cleaning the at least one electrically conductive portion (12) of the electronic component (10), wherein the second step of cleaning is configured to remove oxides from the at least one electrically conductive portion (12), wherein preferably the second step of cleaning comprises a, preferably argon, plasma treatment.
